Europäisches Patentamt

European Patent Office

Office européen des brevets

(19)

(11) **EP 0 710 849 A2**

(12) **EUROPÄISCHE PATENTANMELDUNG**

(43) Veröffentlichungstag:
08.05.1996 Patentblatt 1996/19

(51) Int. Cl.⁶: $G01R\ 33/02$

(21) Anmeldenummer: 95202962.7

(22) Anmeldetag: 02.11.1995

(84) Benannte Vertragsstaaten:
DE FR GB

(30) Priorität: 07.11.1994 DE 4439691

(71) Anmelder:
  • Philips Patentverwaltung GmbH
    22335 Hamburg (DE)
    Benannte Vertragsstaaten:
    DE
  • PHILIPS ELECTRONICS N.V.
    5621 BA Eindhoven (NL)
    Benannte Vertragsstaaten:
    FR GB

(72) Erfinder:
  • Dössel, Olaf, Dr.,
    c/o Philips Patentverw. GmbH
    D-22335 Hamburg (DE)
  • Wischmann, Hans-Aloys, Dr.
    D-22335 Hamburg (DE)
  • Fuchs, Manfred, Dr.,
    c/o Philips Patentverw. GmbH
    D-22335 Hamburg (DE)
  • Steenbrink, Rob,
    c/o Philips Patentverw. GmbH
    D-22335 Hamburg (DE)
  • Oostenveld, Robert,
    c/o Philips Patentverw. GmbH
    D-22335 Hamburg (DE)

(74) Vertreter: Hartmann, Heinrich, Dipl.-Ing.
    Philips Patentverwaltung GmbH,
    Röntgenstrasse 24
    D-22335 Hamburg (DE)

(54) **Verfahren zur Bestimmung der räumlichen Feldverteilung**

(57)    Die Erfindung betrifft ein Verfahren zur Bestimmung der räumlichen Feldverteilung und/oder der Raumlage einer die Feldverteilung verursachenden Nutzfeldquelle mittels einer mehrkanaligen Feldmeßanordnung (1), welche eine Mehrzahl von räumlich verteilten Sensoren aufweist, mittels welcher Meßwerte (M) erzeugt werden, welche einerseits von der Nutzfeldquelle (N) herrührende Nutzmeßwerte und andererseits von mindestens einer Störfeldquelle (S) herrührende Störmeßwerte enthalten, wobei Korrekturwerte (M¹) gebildet und den Meßwerten überlagert werden, wodurch sich kompensierte Meßwerte ($M_k$) ergeben, welche mit gleichartig kompensierten rechnerisch ermittelten Vergleichswerten ($V_k$) verglichen werden, die von einer angenommenen Vergleichs-Feldquelle mittels der Feldsensoren erzeugt würden, und wobei diejenige Vergleichs-Feldquelle ermittelt wird, bei welcher das Muster der kompensierten Vergleichswerte ($V_k$) mit dem Muster der kompensierten Meßwerte ($M_k$) am besten übereinstimmt.

FIG. 1

**Beschreibung**

Die Erfindung bezieht sich auf ein Verfahren zur Bestimmung der räumlichen Feldverteilung und/oder der Raumlage einer die Feldverteilung verursachenden Nutzfeldquelle mittels einer mehrkanaligen Feldmeßanordnung, welche eine Mehrzahl von räumlich verteilten Sensoren aufweist, mittels welcher Meßwerte erzeugt werden, welche einerseits von der Nutzfeldquelle herrührende Nutzmeßwerte und andererseits von mindestens einer Störfeldquelle herrührende Störmeßwerte enthalten, wobei Korrekturwerte gebildet und den Meßwerten überlagert werden, wodurch sich kompensierte Meßwerte ergeben, welche mit gleichartig kompensierten rechnerisch ermittelten Vergleichswerten verglichen werden, die von einer angenommenen Vergleichs-Feldquelle mittels der Feldsensoren erzeugt würden, und wobei diejenige Vergleichs-Feldquelle ermittelt wird, bei welcher das Muster der kompensierten Vergleichswerte mit dem Muster der kompensierten Meßwerte am besten übereinstimmt.

Durch ein solches Verfahren können mittels geeigneter bekannter Sensoren elektrische oder magnetische Feldverteilungen gemessen oder zugehörige Feldquellen geortet werden. Als magnetische Sensoren sind beispielsweise magnetoresistive Elemente geeignet. Hochempfindlich sind auch Sensoren, die die Rotation der Magnetisierung in ferromagnetischen Filmen nutzen. In der medizinischen Meßtechnik sind als Sensoren SQUIDs gebräuchlich.

Vorzugsweise dient das erfindungsgemäße Verfahren dazu, biomagnetische Felder zu messen, welche von im Körper, insbesondere im Kopf oder Herzen, fließenden Strömen hervorgerufen werden.

Ein Verfahren der eingangs genannten Art ist durch die DE-A-43 04 516 bekannt.

Da die zu messenden Nutzfelder im allgemeinen von vielfach stärkeren Störfeldern überlagert sind, die von im Vergleich zur zu untersuchenden Nutzfeldquelle weit entfernten Störfeldquellen hervorgerufen werden, enthalten die Meßwerte außer den gesuchten Nutzmeßwerten relativ große Störmeßwerte. Deshalb müssen Maßnahmen zur Unterdrückung der Störmeßwerte vorgesehen werden. Beim bekannten Verfahren werden aus einem über einen gewissen Zeitraum ermittelten Muster von Meßwerten Störsignalvektoren abgeleitet, die zur Korrektur der Meßwerte herangezogen werden. Dabei wird vorausgesetzt, daß das Störsignal nur eine geringe Ähnlichkeit mit dem Nutzsignal aufweist. Beim Vergleich der Meßwerte mit errechneten Feldwerten wird von einem korrigierten Meßsignalvektor und einem korrigierten Quellensignalvektor ausgegangen.

Wenn man auf aufwendige schwere und teure Abschirmeinrichtungen verzichten will, müssen die Maßnahmen zur Störfeldkompensation besonders wirksam sein. Das gilt insbesondere dann, wenn in der medizinischen SQUID-Meßtechnik keine Gradiometeranordnungen verwendet werden sollen oder können, wie beispielsweise bei mit keramischen Hoch-Temperatur-Supraleitern aufgebauten SQUIDs. Es bestehen nämlich Schwierigkeiten, die für klassische Gradiometeranordnungen erforderlichen supraleitenden Verbindungen herzustellen.

Der Erfindung liegt die Aufgabe zugrunde, ein Verfahren der eingangs genannten Art zu schaffen, mit welchem der Einfluß von Störfeldern weitgehend beseitigbar ist, wobei nicht nur ein räumlich gleichförmiges Störfeld erfaßt werden soll.

Die Lösung gelingt dadurch, daß das Muster der Meßwerte durch eine Korrektur-Funktion angenähert wird, welche eine Anzahl von solchen Termen einer Funktionsreihe enthält, die für den räumlichen Verlauf der Störmeßwerte wesentlich sind, wobei in der Korrektur-Funktion mindestens ein Term der Funktionsreihe nicht enthalten ist, welcher für den räumlichen Verlauf der Nutzmeßwerte wesentlich, für den räumlichen Verlauf der Störmeßwerte jedoch unwesentlich ist, daß kompensierte Meßwerte als Differenz der Meßwerte und der sich an den Stellen der zugehörigen Feldsensoren aufgrund der Korrektur-Funktion ergebenden transformierten Meßwerte gebildet werden, und daß die Vergleichswerte in gleicher Weise in kompensierte Vergleichswerte umgeformt werden.

Mit dem erfindungsgemäßen Verfahren sind Störfeldunterdrückungsfaktoren in der Größenordnung $10^5$ möglich. Die Störfeldunterdrückung ist unabhängig vom zeitlichen Verlauf der Störsignale in jedem Augenblick möglich.

Für die Annäherung des gemessenen Musters von Meßwerten zu einer Korrektur-Funktion sind konvergente mathematische Funktionsreihen geeignet.

Besonders geeignet sind Potenzreihen, jedoch können in besonderen Fällen je nach räumlicher Anordnung der Sensoren und je nach der Charakteristik der Störfelder auch andere Funktionsreihen vorteilhaft sein wie Tschebyscheff-Polynome, trigonometrische Funktionen oder Kugelflächenfunktionen, welche insbesondere bei Helmsystemen zur Messung zerebraler Felder brauchbar sind.

Die Anzahl der zur Bildung der Korrektur-Funktion genutzten Sensoren sollte mindestens um "1" größer sein als die Gesamtzahl der zu ermittelnden Funktionskoeffizienten. Dann erhält man ein überbestimmtes Gleichungssystem, und es werden die die Meßwerte optimal anpassenden Koeffizienten der Korrektur-Funktion bestimmt (linear least squares fit). Je größer die Anzahl der von verschiedenen Sensoren berücksichtigten Meßwerte ist, desto weniger wirkt sich das intrinsische Sensorrauschen auf das Ergebnis aus.

Selbstverständlich sollte die Raumlage der herangezogenen Sensoren derart sein, daß sie linear unabhängige Informationen für die rechnerische Bestimmung der Funktionskoeffizienten zu liefern vermögen. Die Informationen sollten im Interesse einer hohen Genauigkeit signifikant unabhängig sein. In der Praxis bedeutet das, daß die verwendeten Sensoren möglichst über den verfügbaren Raum der Meßanordnung gleichmäßig verteilt sein und einen möglichst großen Abstand voneinander haben sollten. Falls in mehrere Koordinatenrichtungen weisende Feldkomponenten oder Feldvektoren ermittelt werden sollen, muß eine entsprechende Anzahl von Sensoren jeder Koordinatenrichtung zugeordnet werden.

Bei einem einfachen erfindungsgemäßen Verfahren ist vorgesehen, daß die Feldsensoren in einer einzigen Meßebene angeordnet sind, wodurch senkrecht zur Meßebene verlaufende Feldkomponenten ermittelt werden.

Weitere Feldkomponenten können mit zusätzlichen Feldsensoren gemessen werden, die in zur ersten Meßebene geneigten, vorzugsweise orthogonalen Meßebenen angeordnet sind.

Da Feldsensoren fertigungstechnisch nicht mit absoluter Genauigkeit in einer Meßebene angeordnet werden können, können bei Winkelfehlern auch Feldkomponenten aus zur gewollten Meßrichtung orthogonalen Richtungen erfaßt werden. Eine Korrektur ist dadurch möglich, daß den in einer Meßebene angeordneten Feldsensoren Korrektursensoren zur Messung von parallel zur Meßebene verlaufenden Feldkomponenten zugeordnet sind, und daß mittels Korrekturschaltungen die Meßwerte von ungewollt geneigt zur Meßebene angeordneten Feldsensoren mittels der durch die Korrektursensoren erhaltenen Meßwerte korrigiert werden.

Das erfindungsgemäße Verfahren ist natürlich auch entsprechend anwendbar, wenn Meßwerte als Differenzen von im Abstand voneinander detektierten Feldstärken vorliegen, beispielsweise mittels Gradiometer-Anordnungen. Dementsprechend werden dann zur Messung von Feldgradienten Feldsensoren in mehreren zueinander parallelen Ebenen vorgesehen.

Die Sensor-Signale weisen wegen des hohen Störanteils im Vergleich zum eigentlichen Nutzsignal einen sehr hohen Pegel auf. Zur besseren Nutzung des Dynamikbereichs nachfolgender Verstärker, insbesondere A/D-Wandler, ist es besonders vorteilhaft, daß als Meßwerte die Differenzen der mittels der Feldsensoren und mittels eines gleichachsigen Pegelsensors gemessenen Werte gewählt werden, und daß die Vergleichswerte ebenfalls um den Wert der Korrektur- Funktion am Ort des Pegelsensors erniedrigt werden. Dabei sollten die Differenzen am Ausgang der Sensoren durch analoge Schaltungen gebildet werden und insbesondere dadurch, daß die Ausgangsspannung des Pegelsensors den Ausgangsspannungen der Meßsensoren überlagert wird.

Die Lösung der der Erfindung zugrundeliegenden Aufgabe gelingt außerdem durch eine Meßanordnung zur Bestimmung der räumlichen Feldverteilung und/oder der Raumlage einer die Feldverteilung verursachenden Nutzfeldquelle, bestehend aus:

- einer mehrkanaligen Feldmeßanordnung, welche eine Mehrzahl von räumlich verteilten Sensoren aufweist, mittels welcher Meßwerte erzeugt werden, welche einerseits von der Nutzfeldquelle herrührende Nutzmeßwerte und andererseits von mindestens einer Störfeldquelle herrührende Störmeßwerte enthalten,
- einer Korrekturschaltung zur Bildung von Korrekturwerten, welche den Meßwerten überlagert werden, wodurch sich kompensierte Meßwerte als Differenz der Meßwerte und der sich an den Stellen der zugehörigen Feldsensoren aufgrund einer Korrektur-Funktion ergebenden Werte gebildet werden,
- einer Rechenschaltung zum Ermitteln von Vergleichswerten, die von einer angenommenen Vergleichs-Feldquelle mittels der Feldsensoren erzeugt würden, und zum Kompensieren dieser Vergleichswerte in gleicher Weise wie in der Korrektur-Schaltung, wodurch sich kompensierte Vergleichswerte ergeben,
- einer Vergleichsschaltung zum Vergleichen der kompensierten Meßwerte mit den kompensierten Vergleichswerten, wobei diejenige Vergleichs-Feldquelle ermittelt wird, bei welcher das Muster der kompensierten Vergleichswerte mit dem Muster der kompensierten Meßwerte am besten übereinstimmt, wobei das Muster der Meßwerte durch eine Korrektur-Funktion angenähert wird, welche eine Anzahl von solchen Termen einer Funktionsreihe enthält, die für den räumlichen Verlauf der Störmeßwerte wesentlich sind, und wobei in der Korrektur-Funktion mindestens ein Term der Funktionsreihe nicht enthalten ist, welcher für den räumlichen Verlauf der Nutzmeßwerte wesentlich, für den räumlichen Verlauf der Störmeßwerte jedoch unwesentlich ist.

Vorteilhafte Ausgestaltungen dieser Meßanordnung ergeben sich aus den abhängigen Ansprüchen.
Ausführungsbeispiele der Erfindung werden in Verbindung mit der Zeichnung erläutert.

Fig. 1    zeigt ein Ablaufdiagramm des erfindungsgemäßen Verfahrens

Fig. 2    zeigt schematisch eine Anordnung von in einer Meßebene winkelgleich angeordneten Sensoren

Fig. 3    zeigt in drei zueinander parallelen Ebenen angeordnete Sensoren

Fig. 4    zeigt eine Prinzipschaltung zu analogen Subtraktionen des Signals eines Pegel-Sensors von den Signalen der übrigen Sensoren

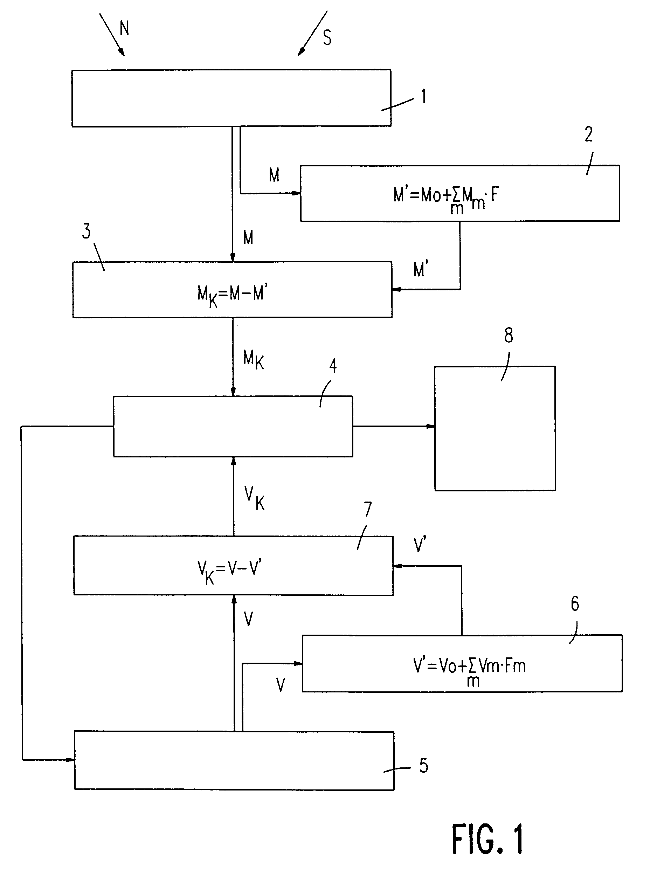

Anhand Fig. 1 wird die allgemeine Wirkungsweise des erfindungsgemäßen Verfahrens näher erläutert.

Gemessen werden soll in einem Flächenabschnitt oder in einem Raumabschnitt mittels einer Meßanordnung 1 die Feldverteilung eines Nutzfeldes N, welchem ein großes Störfeld S überlagert ist. Beispielsweise ist die Meßanordnung 1 entsprechend Appl.Phys.lett. 63, 1963, Seiten 2700-2702 aufgebaut und enthält eine Mehrzahl von räumlich verteilten Gleichstrom-SQUID-Magnetometern als Sensoren sowie erforderliche Hilfseinrichtungen wie Verstärker und dgl.

Biomagnetische Quellen, welche im Abstand von etwa 5 cm bis 10 cm zur Meßeinrichtung angeordnet sind, erzeugen an den Stellen der Sensoren Flußdichten von ca. 100 fT. Störfelder rühren von Störquellen her, deren Abstand vielfach größer ist und Flußdichten von ca. 100 pT verursachen.

Die einzelnen Sensoren liefern individuelle Meßwerte Mi, deren Gesamtheit mit M bezeichnet ist. Es handelt sich um ein Muster von in einem Flächen- oder Raumelement ermittelten individuellen Meßwerten.

Wegen der erheblich unterschiedlichen Abstände der Nutzfeldquelle und der Störfeldquelle von der Meßanordnung sind die räumlichen Charakteristiken der Nutzmeßwerte und der Störmeßwerte signifikant verschieden voneinander. Wenn man die Nutzmeßwerte und die Störmeßwerte jeweils durch eine gleiche mathematische Funktionsreihe (insbesondere Potenz-Reihe) anpaßt, erkennt man, daß für einige Terme die zugehörigen Funktionskoeffizienten bei der Anpassung der Nutzmeßwerte stark ausgeprägt sind, während die entsprechenden Koeffizienten dieser Terme bei der Anpassung der Störmeßwerte praktisch vernachlässigbar sind.

Die Meßwerte M werden durch eine Korrektur-Funktion M' angepaßt, in welcher zumindest ein Term der gewählten Funktionsreihe nicht enthalten ist, dessen Koeffizient bei Erfassung nur der Nutzmeßwerte beachtlich, bei Erfassung nur der Störmeßwerte dagegen unbeachtlich wäre. Dabei ergibt sich M' mittels einer Rechenschaltung 2 als Summe eines konstanten Wertes Mo und einer Summe der Produkte ausgewählter Funktionstermen Fm und ihrer zugehörigen Koeffizienten Mm.

In einer Rechenschaltung 3 werden kompensierte Meßwerte Mk als Differenzen der ursprünglichen Meßwerte M und der aus der Korrektur-Funktion errechneten Werte M' gebildet. Die Werte Mk werden einer Vergleichschaltung 4 zugeführt, mittels welcher dann aufgrund der Werte Mk die Nutzfeldverteilung und/oder die Raumlage der zugehörigen Nutzfeldquelle errechnet wird. Dazu werden mittels der Rechenschaltung 5 Vergleichswerte V von verschiedenen angenommenen Nutzfeldquellen errechnet, welche jeweils in den Sensoren gemessen werden würden. Das Muster dieser fiktiven Vergleichswerte V wird in gleicher Weise wie das Muster der Meßwerte M durch eine Korrektur-Funktion V' als Summe eines konstanten Wertes Vo und der Summe des Produkts der für die Meßwerte M gewählten Terme Fm und der zugehörigen Koeffizienten Vm angepaßt (Rechenschaltung 6). In der Rechenschaltung 7 werden kompensierte Vergleichswerte Vk aus der Differenz der errechneten Vergleichswerte V und der für gleiche Meßorte errechneten transformierten Werte V' gebildet. In der Vergleichsschaltung 4 werden die Werte Mk und Vk miteinander verglichen. Bei Abweichungen wird der Vorgang mit neuen Vergleichswerten V einer anderen fiktiven Nutzfeldquelle wiederholt, bis optimale Übereinstimmung erreicht wurde. Danach können die Daten der optimalen Vergleichsquelle als Daten der Nutzfeldquelle einer Ausgabeeinrichtung 8 übermittelt werden.

Bei den mit Bezug auf Fig. 1 genannten Größen kann es sich um Vektoren oder um skalare Komponenten handeln.

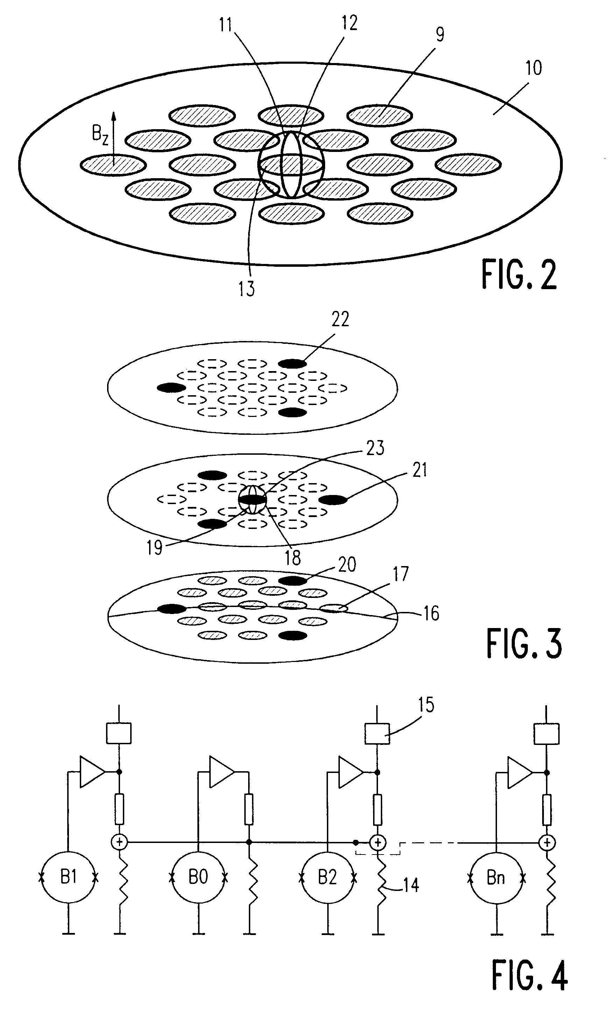

Gemäß Fig. 2 sind 19 z-Magnetometer 9 in einer Meßebene 10 gleichachsig angeordnet. Damit können 19 verschiedene Induktionen Bz in z-Richtung senkrecht zur Meßebene 10 gemessen werden. Zusätzlich sind Korrektur-Magnetometer 11 und 12 im Bereich des zentralen z-Magnetometers 13 vorgesehen, mittels welcher Induktionen Bx und By in x- bzw. y-Richtung parallel zur Meßebene gemessen werden können.

Mittels der z-Magnetometer (Anzahl n+1=19) werden Induktionen $B_i = B_o$ bis $B_n$ an den Orten mit den Koordinaten $x_i$ und $y_i$ in der Meßebene 10 gemessen.

Als Korrektur-Funktion wurde eine nach dem quadratischen Term abgebrochene Taylor-Potenzreihe als geeignet ermittelt. Deren Entwicklungskoeffizienten $G_K = G_o$ bis $G_5$ lassen sich durch folgendes Gleichungssystem berechnen:

$$B_0 = G_0 + G_1\, x_0 + G_2\, y_0 + G_3\, x_0 y_0 + G_4\, x_0 x_0 + G_5\, y_0 y_0$$

$$B_1 = G_0 + G_1\, x_1 + G_2\, y_1 + G_3\, x_1 y_1 + G_4\, x_1 x_1 + G_5\, y_1 y_1$$

.

.

.

$$B_n = G_0 + G_1\, x_n + G_2\, y_n + G_3\, x_n y_n + G_4\, x_n x_n + G_5\, y_n y_n$$

In Vektorschreibweise lautet dieses Gleichungssystem:

$$\underline{B} = \underline{G} * \underline{X}$$

mit

$$\underline{B} = (B_0 \dots B_n)$$

$$\underline{G} = (G_0 \dots G_5)$$

$$\underline{\underline{X}} = \begin{pmatrix} 1 & \dots & 1 \\ x_0 & \dots & x_n \\ y_0 & \dots & y_n \\ x_0 y_0 & \dots & x_n y_n \\ x_0^2 & \dots & x_n^2 \\ y_0^2 & \dots & y_n^2 \end{pmatrix}$$

Durch Lösung des Gleichungssystems werden die Koeffizienten $G_k$ bestimmt. Für das erfindungsgemäße Verfahren ist es vorteilhaft, daß n deutlich größer als 6 ist. Dann ist das System überbestimmt, und es werden diejenigen Koeffizienten $G_k$ bestimmt, mit denen die Meßwerte $B_i$ optimal angepaßt werden (linear least squares fit). Je größer die Zahl der Magnetometer ist, um so weniger wirkt sich das intrinsische Sensorrauschen auf das Ergebnis aus.

$$\underline{G} = \underline{B} \ast \underline{\underline{X}}^T (\underline{\underline{X}} \ast \underline{\underline{X}}^T)^{-1}$$

Dann wird das mit dieser Näherung am Ort des i-ten Magnetometers berechnete Störsignal vom Meßsignal am Ort i subtrahiert:

$$B_i^{\ast} = B_i - (G_0 + G_1 x_i + G_2 y_i + G_3 x_i y_i + G_4 x_i x_i + G_5 y_i y_i)$$

$$\underline{B}^{\ast} = \underline{B} - \underline{G} \ast \underline{\underline{X}}$$

So wird erreicht, daß nicht nur der mittlere Magnetfeld-Hintergrund und der mittlere Gradient 1. Ordnung subtrahiert wird, sondern es wird auch eine quadratische Krümmung des Magnetfeldes mit kompensiert. Das biomagnetische Signal weist wegen der räumlichen Nähe der Quellen zu den Magnetometern eine stärkere Krümmung (Terme dritter und höherer Ordnung) im Verlauf des Magnetfeldes auf, die als eigentliches Meßsignal extrahiert wird.

Um den Dynamikbereich von den Magnetometern nachgeordneten elektrischen Schaltungen nicht zu überschreiten, wird das Signal $B_0$ des zentralen z-Magnetometers 13 von allen anderen Signalen $B_1$ bis $B_n$ subtrahiert. Dies kann vorteilhaft durch eine kleine Einkoppelspule an jedem anderen Sensor erfolgen (Fig. 4). Diese Spulen sind meistens ohnehin vorhanden, da mit ihrer Hilfe und einem gegengekoppelten Regelkreis die Magnetometer als Nulldetektor betrieben werden. Auch ist eine analoge Subtrahierer-Schaltung vor jedem A/D-Konventer 15 möglich. Es kann auch Gründe geben, daß das Signal des zentralen z-Magnetometers als globales externes Gegenfeld durch eine große Spulen-Anordnung erzeugt werden muß, wodurch die gleiche Wirkung erzielt wird.

Um den Neigungsfehler der Magnetometer zu kompensieren, wird dieser Fehler zunächst exakt vermessen. Dies kann mit einer Helmholtzspulen-Anordnung erfolgen, mit der nacheinander ein homogenes Feld in x-, y- und z-Richtung angelegt wird. Die drei Meßsignale in [V] dividiert durch die Magnetfeldstärke in [T] können als Komponenten eines Normalvektors des Magnetometer aufgefaßt werden, wobei die Länge des Vektors die Empfindlichkeit angibt: $Q_{ix}, Q_{iy}, C_{iz}$. (Q steht für "Querempfindlichkeit".) Die Empfindlichkeit des x- bzw. y-Magnetometers in x- bzw. y-Richtung sei $C_{0x}$ bzw. $C_{0y}$.

Mit den zentralen x-, y- und z-Magnetometern in der vorgeschlagenen Anordnung wird der Vektor des Magnetfeldes an dieser Stelle gemessen: $B_{0x} = S_{0x}/C_{0x}$, $B_{0y} = S_{0y}/C_{0y}$, $B_{0z} = S_{0z}/C_{0z}$. Nun können die Signale aller anderen Magnetometer $S_i$[V] folgendermaßen korrigiert werden (der analoge Abzug des Signals vom zentralen z-Kompensations-Magnetometer $S_{0z}/C_{0z}$ wie oben beschrieben wurde hier mit berücksichtigt):

$$B_{irei} = S_i/C_{iz} - (S_{0x}/C_{0x}) \ast (Q_{ix}/C_{iz}) - (S_{0y}/C_{0y}) \ast (Q_{iy}/C_{iz}) - S_{0z}/C_{0z}$$

Hierbei wird näherungsweise angenommen, daß das Störfeld am Ort der einzelnen Magnetometer gleich dem Feld am Ort des zentralen dreiachsigen Magnetometers ist. Dies ist natürlich nur eine grobe Näherung. Die Koeffizienten $Q_{ix}$ und $Q_{iy}$ sind aber bei präziser Bauweise der Anordnung nur 1/100 von $C_{iz}$ und stellen daher nur eine Korrekturgröße dar. Deshalb kann hier mit dieser Näherung gearbeitet werden.

Gelingt eine besonders präzise Bauweise mit extrem kleinen Neigungsfehlern der z-Magnetometer, kann die Korrektur durch die x- bzw. y-Magnetometer auch entfallen.

Falls eine genauere Korrektur der Neigungsfehler erforderlich ist, können mittels mehrerer x- und y-Magnetometer pro Meßebene genauere Korrekturfunktionen für die x- und y-Feldkomponente gebildet werden, welche deren räumlichen Verlauf genauer wiedergeben.

Natürlich müssen alle Manipulationen am Meßsignal im Rekonstruktions-Algorithmus berücksichtigt werden. Dies ist relativ leicht möglich; da eine analytische Lösung des inversen Problems nicht existiert, wird immer das "Vorwärtsproblem" gelöst und die berechnete an die gemessene Feldverteilung angepaßt. Im "Vorwärtsproblem" können aber alle oben angegebenen Korrekturen exakt nachvollzogen werden.

Bei einer vorteilhaften Anordnung gemäß Fig. 3 wird auch die Ableitung der Magnetfelder in z-Richtung mit berücksichtigt. Dies ist dann von Bedeutung, wenn nicht alle Bio-Magnetometer in einer Ebene liegen. In Fig. 3 soll die Linie 16 andeuten, daß die z-Magnetometer 17 in einer gewölbten Fläche verteilt sind.

Vorgesehen sind mehrere Magnetometer für die z-Richtung und je ein Korrektur-Magnetometer 18 bzw. 19 für die x- und y-Richtung. Beliebig viele Bio-Magnetometer 17 in z-Richtung werden von Kompensations-Magnetometern 20, 21 und 22 eingerahmt, die in verschiedenen Ebenen angeordnet sind, welche in z-Richtung einen Abstand zueinander haben. Diese z-Kompensations-Magnetometer sind auf den Ecken von drei großen gleichseitigen Dreiecken angeordnet, die einen Abstand von jeweils 50 mm bis 100 mm haben. In jeder Ebene sind z-Kompensations-Gradiometer auf einem gleichseitigen Dreieck angeordnet. Ein zehntes z-Kompensations-Magnetometer 23 befindet sich zusammen mit den x- und y-Korrekturen-Magnetometern in der Mitte des Dreiecks in der mittleren Ebene.

Hier lautet das Gleichungssystem zur Bestimmung der Koeffizienten der transformierten Funktion:

$$B_0 = G_0 + G_1\, x_0 + G_2\, y_0 + G_3\, z_0 + G_4\, x_0 y_0 + G_5\, x_0 z_0 + G_6\, y_0 z_0 + G_7\, x_0 x_0 + G_8\, y_0 y_0$$
$$+ G_9\, z_0 z_0$$

$$B_1 = G_0 + G_1\, x_1 + G_2\, y_1 + G_3\, z_1 + G_4\, x_1 y_1 + G_5\, x_1 z_1 + G_6\, y_1 z_1 + G_7\, x_1 x_1 + G_8\, y_1 y_1$$
$$+ G_9\, z_1 z_1$$

$$\cdot$$
$$\cdot$$
$$\cdot$$

$$B_9 = G_0 + G_1\, x_9 + G_2\, y_9 + G_3\, z_9 + G_4\, x_9 y_9 + G_5\, x_9 z_9 + G_6\, y_9 z_9 + G_7\, x_9 x_9 +$$
$$G_8\, y_9 y_9 + G_9\, z_9 z_9$$

Oder wieder einfacher in Vektorschreibweise:

$$\underline{B} = \underline{G} \,{}^* \underline{X}$$

mit

$$\underline{\underline{X}} = \begin{pmatrix} 1 & \dots & 1 \\ x_0 & \dots & x_9 \\ y_0 & \dots & y_9 \\ z_0 & \dots & z_9 \\ x_0 y_0 & \dots & x_9 y_9 \\ x_0 z_0 & \dots & x_9 z_9 \\ y_0 z_0 & \dots & y_9 z_9 \\ x_0^2 & \dots & x_9^2 \\ y_0^2 & \dots & y_9^2 \\ z_0^2 & \dots & z_9^2 \end{pmatrix}$$

Dieses Gleichungssystem läßt sich exakt lösen.

Die einzelnen Meßwerte der Bio-Magnetometer werden dann folgendermaßen korrigiert:

$$B_i^* = B_i - (G_0 + G_1 x_i + G_2 y_i + G_3 z_i + G_4 x_i y_i + G_5 x_i z_i + G_6 y_i z + G_7 x_i x_i + G_8 y_i y_i + G_9 z_i z_{i)}$$

Hinzu kommt noch möglicherweise die oben beschriebene Korrektur der Neigungswinkel der Magnetometer durch die Magnetometer in x- bzw. y-Richtung und die bessere Ausnutzung des Dynamikbereiches durch analogen Abzug eines zentralen z-Magnetometer-Signals.

Für die beschriebene oder für andere mögliche Anordnungen von Magnetometern ist nur wichtig, daß die Koeffizienten-Matrix X nicht singulär ist. Darüber hinaus sollte die in dieser Matrix enthaltene Information sogar weitgehend linear unabhängig sein, damit die Koeffizienten $G_i$ stabil berechnet werden können. Dies ist insbesondere bei den beschriebenen Anordnungen der Fall.

In einer weniger stark gestörten Umgebung ist es auch möglich, die Taylor-Reihe schon nach dem linearen Term abzubrechen.

Ob die Magnetometer, die für die Berechnung der Korrekturkoeffizienten herangezogen werden, selber viel biomagnetisches Signal enthalten oder weniger, ist nicht entscheidend. Es sollte darauf geachtet werden, daß nicht zuviel biomagnetisches Signal durch die Korrektur verloren geht. Als Maß kann hierbei die mittlere Signalamplitude eines Stromdipols (typische biomagnetische Quelle) dienen:

$$A_v = \sqrt{\frac{\Sigma B_i^2}{N}} \text{ vor Korrekturmaßnahmen und}$$

$$A_m = \sqrt{\frac{\Sigma B_i^2}{N}} \text{ nach Korrekturmaßnahmen (N: Zahl der Magnetometer)}$$

Die mittlere Amplitude für nahgelegene Stromdipole sollte nach der Störfeld-Kompensation nicht auf Werte kleiner als ca. 10% sinken. Dies ist bei den beschriebenen Anordnungen der Fall.

Bei analogem Vergleich der berechneten Amplitude eines störenden magnetischen Dipols in einigen Metern Entfernung vor und nach der Kompensation zeigt sich, daß bei einer Potenzreihe bis zur 2. Ordnung Störfeldunterdrückungs-Faktoren von $10^5$ erreicht werden.

Es können auch andere Funktionen als Polynome für eine Reihenentwicklung herangezogen werden. Wichtig ist nur, daß das Abbrechen der Reihenentwicklung nach einem der ersten Terme zu einer räumlichen Hochpaßfilterung führt.

Die Korrektur von Störsignalen durch eine Potenzreihe, wie oben beschrieben, läßt sich auch auf Anordnungen mit klassischen Gradiometern anwenden.

Die genannten Korrekturformeln gelten analog, wenn für B die Ausgangssignale der Gradiometer eingesetzt werden. Auch die Querempfindlichkeit der Gradiometer kann durch x- und y-Magnetometer entsprechend korrigiert werden.

Analog dem beschriebenen Verfahren lassen sich auch andere Magnetfeld-Komponenten als die oben beschriebene z-Komponente ermitteln. Z. B. können an vielen Orten jeweils drei orthogonale Magnetometer angeordnet sein. Es wird dann sowohl die z- als auch die x- und y-Komponente in eine Potenzreihe entwickelt. Die Meßwerte werden wieder entsprechend durch Abzug der linear und/oder quadratischen Terme korrigiert. Die Orte für die dreiachsigen Magnetometer müssen so angeordnet sein, daß keine der Koeffizienten-Matrizen singulär ist. Solche Anordnungen sind für Systeme wichtig, bei denen die biomagnetischen Signale um den ganzen Kopf herum (Helmsystem) oder um den Oberkörper herum aufgezeichnet werden sollen, wobei die Magnetometer gleichmäßig um den Kopf oder den Oberkörper verteilt werden. Wenn die x-, die y- und die z-Komponente des Magnetfeldes vollkommen unabhängig behandelt werden, verdreifacht sich für gleiche Störfeld-Unterdrükkungsfaktoren die Zahl der Magnetometer im Vergleich zur Messung in nur einer Koordinatenrichtung.

Solche dreidimensionalen Systeme kann man dadurch weiter vereinfachen, daß man die aus den Maxwell-Gleichungen folgenden Beziehungen zwischen den Komponenten eines Flußdichte-Vektorfeldes konsequent berücksichtigt.

Wenn die Korrektur-Funktion bis zu den quadratischen Termen einer Taylorreihe gebildet wird, läßt sich zeigen, daß 15 linear-unabhängige Gleichungen für die im Korrekturalgorithmus zu bestimmenden Taylor-Koeffizienten angegeben werden können, so daß die Zahl der für eine gleiche Störfeldunterdrückung notwendigen Magnetometer um 15 reduziert werden kann.

Die linear-unabhängigen Gleichungen für die Taylor-Koeffizienten ergeben sich wie folgt:

Ansatz für die Taylor-Entwicklung:

$$B_x(x,y,z) = A_0 + A_1 x + A_2 y + A_3 z + A_4 x^2 + A_5 y^2 + A_6 z^2 + A_7 xy + A_8 yz + A_9 xz$$

$$B_y(x,y,z) = B_0 + B_1 x + B_2 y + B_3 z + B_4 x^2 + B_5 y^2 + B_6 z^2 + B_7 xy + B_8 yz + B_9 xz$$

$$B_z(x,y,z) = C_0 + C_1 x + C_2 y + C_3 z + C_4 x^2 + C_5 y^2 + C_6 z^2 + C_7 xy + C_8 yz + C_9 xz$$

Berechnung der Ableitungen:

$$\frac{\partial B_x}{\partial x} = A_1 + 2A_4 x + A_7 y + A_9 z$$

$$\frac{\partial B_x}{\partial y} = A_2 + 2A_5 y + A_7 x + A_8 z$$

$$\frac{\partial B_x}{\partial z} = A_3 + 2A_6 z + A_8 y + A_9 x$$

Analoge Gleichungen gelten für $B_y$ und $B_z$.

Aus der Maxwell-Gleichung div B = 0 folgt nun:

$$A_1 + 2A_4 x + A_7 y + A_9 z + B_2 + 2B_5 y + B_7 x + B_8 z + C_3 + 2C_6 z + C_8 y + C_9 x = 0 \quad \forall x,y,z$$

Hieraus ergeben sich folgende linear-unabhängige Gleichungen:

$$A_1 + B_2 + C_3 = 0$$

$$2A_4 + B_7 + C_9 = 0$$

$$A_7 + 2B_5 + C_8 = 0$$

$$A_9 + B_8 + 2C_6 = 0$$

Aus der Maxwell-Gleichung rot B = 0 (außerhalb des Körpers fließen keine Ströme!) folgt weiterhin:

$$(B_3 + 2B_6 z + B_8 y + B_9 x) - (C_2 + 2C_5 y + C_7 x + C_8 z) = 0$$

$$(C_1 + 2C_4 x + C_7 y + C_9 z) - (A_3 + 2A_6 z + A_8 y + A_9 x) = 0$$

$$(A_2 + 2A_5 y + A_7 x + A_8 z) - (B_1 + 2B_4 x + B_7 y + B_9 z) = 0 \quad \forall x,y,z$$

Hieraus folgen weitere linear-unabhängige Gleichungen:

$$B_3 - C_2 = 0 \qquad C_1 - A_3 = 0 \qquad A_2 - B_1 = 0$$

$$B_9 - C_7 = 0^* \qquad 2C_4 - A_9 = 0 \qquad A_7 - 2B_4 = 0$$

$$B_8 - 2C_5 = 0 \qquad C_7 - A_8 = 0^* \qquad 2A_5 - B_7 = 0$$

$$2B_6 - C_8 = 0 \qquad C_9 - 2A_6 = 0 \qquad A_8 - B_9 = 0^*$$

Von den drei Gleichungen mit $^*$ sind nur zwei linear-unabhängig, die dritte ist damit identisch erfüllt. Alle anderen Gleichungen sind linear-unabhängig, daher ist die Zahl der linear-unabhängigen Gleichungen 15.

Soll, wie vorher beschrieben, das gemessene Magnetfeld in eine Taylorreihe bis zur zweiten Ordnung entwickelt werden, so muß das folgende Gleichungssystem gelöst werden:

$$\underline{B} = \begin{pmatrix} a & d & e & f & (-l-p) & l & p & (2k) & (2l) & (2j) \\ b & e & g & h & k & (-k-n) & n & (2l) & (2m) & (2i) \\ c & f & h & (-d-g) & j & m & (-j-m) & (2i) & (2n) & (2p) \end{pmatrix} {}^* \underline{X}$$

$$\underline{B} = \underline{\underline{U}} {}^* \underline{X}$$

mit

$$\underline{B}(x,y,z) = (B_x(x,y,z), B_y(x,y,z) B_z(x,y,z))^T$$

$$\underline{X} = (1, x, y, z, x^2, y^2, z^2, xy, yz, xz)^T$$

Werden beispielsweise an mindestens fünf geeigneten Punkten $B_x, B_y$ und $B_z$ gemessen, so lassen sich die Koeffizienten a...p berechnen. Vorteilhaft ist wieder die Messung an deutlich mehr als fünf Punkten und die Bestimmung derjenigen Koeffizienten a...p, die die Meßwerte optimal anpassen. Hierzu bietet sich folgendes Verfahren an:

$$\delta^2 = \sum_i (B_i - \underline{n}_i{}^T {}^* \underline{\underline{U}} {}^* \underline{X}_i)^2 \text{ mit } \delta^2 = \text{Min}$$

$n_j$ sind die Normalenvektoren der Magnetometer:

$$\underline{n}_i = (n_{xi}, n_{yi}, n_{zi})^T \text{ und } \underline{X}_i = (1, x_i, y_i, z_i, x_i{}^2 ...)^T$$

Die Ableitungen

$$\frac{\partial \delta^2}{\partial a} = 0, \ \frac{\partial \delta^2}{\partial b} = 0, ......$$

liefern dann die gesuchten Koeffizienten a.....p der Matrix $\underline{U}$.

Dann können alle Meßwerte folgendermaßen korrigiert werden:

$$\underline{B}_i{}^{corr} = \underline{B}_i{}^{ori} - \underline{\underline{U}} {}^* \underline{X}_i$$

Eine andere vorteilhafte Ausgestaltung (z.B. beim für das sogenannte "Helmsystem") weist Meßsensoren gleichmäßig verteilt auf einer stark gekrümmten Fläche auf, die jeweils die zur Fläche senkrechte Komponente des Magnetfeldes bestimmen. Dabei ist zu beachten, daß die Meßsensoren Meßwerte ermitteln, welche Anteile der Feldkomponenten in x - und/oder y- und/oder z-Richtung umfassen. Dadurch werden der Rechenaufwand und das Gleichungssystem zur Bestimmung der Funktionskoeffizienten komplizierter.

## Patentansprüche

1. Verfahren zur Bestimmung der räumlichen Feldverteilung und/oder der Raumlage einer die Feldverteilung verursachenden Nutzfeldquelle mittels einer mehrkanaligen Feldmeßanordnung, welche eine Mehrzahl von räumlich verteilten Sensoren aufweist, mittels welcher Meßwerte erzeugt werden, welche einerseits von der Nutzfeldquelle herrührende Nutzmeßwerte und andererseits von mindestens einer Störfeldquelle herrührende Störmeßwerte enthalten, wobei Korrekturwerte gebildet und den Meßwerten überlagert werden, wodurch sich kompensierte Meßwerte ergeben, welche mit gleichartig kompensierten rechnerisch ermittelten Vergleichswerten verglichen werden, die von einer angenommenen Vergleichs-Feldquelle mittels der Feldsensoren erzeugt würden, und wobei diejenige VergleichsFeldquelle ermittelt wird, bei welcher das Muster der kompensierten Vergleichswerte mit dem Muster der kompensierten Meßwerte am besten übereinstimmt,

dadurch gekennzeichnet, daß das Muster der Meßwerte durch eine Korrektur- Funktion angenähert wird, welche eine Anzahl von solchen Termen einer Funktionsreihe enthält, die für den räumlichen Verlauf der Störmeßwerte wesentlich sind, wobei in der Korrektur-Funktion mindestens ein Term der Funktionsreihe nicht enthalten ist, welcher für den räumlichen Verlauf der Nutzmeßwerte wesentlich, für den räumlichen Verlauf der Störmeßwerte jedoch unwesentlich ist, daß kompensierte Meßwerte als Differenz der Meßwerte und der sich an den Stellen der zugehörigen Feldsensoren aufgrund der Korrektur-Funktion ergebenden Werte gebildet werden, und daß die Vergleichswerte in gleicher Weise in kompensierte Vergleichswerte umgeformt werden.

2.    Verfahren nach Anspruch 1,
dadurch gekennzeichnet, daß als Funktionsreihe Polynome einer Taylorreihe oder Tschebyscheff-Polynome oder trigonometrische Funktionen oder Kugelflächenfunktionen gebildet werden.

3.    Verfahren nach Anspruch 1 oder 2,
dadurch gekennzeichnet, daß die Feldsensoren in einer einzigen Meßebene angeordnet sind, wodurch senkrecht zur Meßebene verlaufende Feldkomponenten ermittelt werden.

4.    Verfahren nach Anspruch 1 oder 2,
dadurch gekennzeichnet, daß drei Gruppen von Feldsensoren in drei orthogonalen Meßebenen angeordnet werden.

5.    Verfahren nach Anspruch 4,
dadurch gekennzeichnet, daß die sich aus den Maxwell-Gleichungen (div B = 0, rot B = 0) ergebenden Randbedingungen in die Ermittlung der Korrekturfunktion einbezogen werden.

6.    Verfahren nach einem der Ansprüche 3 bis 5,
dadurch gekennzeichnet, daß den in einer Meßebene angeordneten Feldsensoren Korrektursensoren zur Messung von parallel zur Meßebene verlaufenden Feldkomponenten zugeordnet sind, und daß mittels Korrekturschaltungen die Meßwerte von ungewollt geneigt zur Meßebene angeordneten Feldsensoren mittels der durch die Korrektursensoren erhaltenen Meßwerte korrigiert werden.

7.    Verfahren nach einem der Ansprüche 1 bis 6,
dadurch gekennzeichnet, daß als Meßwerte die Differenzen der mittels der Feldsensoren und mittels eines gleichachsigen Pegelsensors gemessenen Werte gewählt werden, und daß die Vergleichswerte ebenfalls um den Wert der Korrekturfunktion am Ort des Pegelsensors erniedrigt werden.

8.    Verfahren nach Anspruch 7,
dadurch gekennzeichet, daß die Differenzen am Ausgang der Sensoren durch analoge Schaltungen gebildet werden.

9.    Verfahren nach einem der Ansprüche 1 bis 8,
dadurch gekennzeichnet, daß die Sensoren auf einer stark gekrümmten Meßebene gleichmäßig verteilt angeordnet werden.

10.   Meßanordnung zur Bestimmung der räumlichen Feldverteilung und/oder der Raumlage einer die Feldverteilung verursachenden Nutzfeldquelle, bestehend aus

-    einer mehrkanaligen Feldmeßanordnung, welche eine Mehrzahl von räumlich verteilten Sensoren aufweist, mittels welcher Meßwerte erzeugt werden, welche einerseits von der Nutzfeldquelle herrührende Nutzmeßwerte und andererseits von mindestens einer Störfeldquelle herrührende Störmeßwerte enthalten,
-    einer Korrekturschaltung zur Bildung von Korrekturwerten, welche den Meßwerten überlagert werden, wodurch sich kompensierte Meßwerte als Differenz der Meßwerte und der sich an den Stellen der zugehörigen Feldsensoren aufgrund einer Korrektur-Funktion ergebenden Werte gebildet werden,

- einer Rechenschaltung zum Ermitteln von Vergleichswerten, die von einer angenommenen Vergleichs-Feldquelle mittels der Feldsensoren erzeugt würden, und zum Kompensieren dieser Vergleichswerte in gleicher Weise wie in der Korrektur-Schaltung, wodurch sich kompensierte Vergleichswerte ergeben,

- einer Vergleichsschaltung zum Vergleichen der kompensierten Meßwerte mit den kompensierten Vergleichswerten, wobei diejenige Vergleichs-Feldquelle ermittelt wird, bei welcher das Muster der kompensierten Vergleichswerte mit dem Muster der kompensierten Meßwerte am besten übereinstimmt, wobei das Muster der Meßwerte durch eine Korrektur-Funktion angenähert wird, welche eine Anzahl von solchen Termen einer Funktionsreihe enthält, die für den räumlichen Verlauf der Störmeßwerte wesentlich sind, und wobei in der Korrektur-Funktion mindestens ein Term der Funktionsreihe nicht enthalten ist, welcher für den räumlichen Verlauf der Nutzmeßwerte wesentlich, für den räumlichen Verlauf der Störmeßwerte jedoch unwesentlich ist.

11. Meßanordnung nach Anspruch 10,
dadurch gekennzeichnet, daß die Feldsensoren in einer einzigen Meßebene angeordnet sind, wodurch senkrecht zur Meßebene verlaufende Feldkomponenten ermittelt werden.

12. Meßanordnung nach Anspruch 10,
dadurch gekennzeichnet, daß drei Gruppen von Feldsensoren in drei orthogonalen Meßebenen angeordnet sind.

13. Meßanordnung nach einem der Ansprüche 10 bis 12,
dadurch gekennzeichnet, daß analoge Schaltungen zur Differenzenbildung am Ausgang der Sensoren vorgesehen sind.

14. Meßanordnung nach einem der Ansprüche 10 bis 13,
dadurch gekennzeichnet, daß die Sensoren auf einer stark gekrümmten Meßebene gleichmäßig verteilt angeordnet sind.

FIG. 1

FIG. 2

FIG. 3

FIG. 4